(19) Europäisches Patentamt

European Patent Office

Office européen des brevets

(11) Veröffentlichungsnummer: **0 285 090 B1**

# (12) EUROPÄISCHE PATENTSCHRIFT

(45) Veröffentlichungstag der Patentschrift: **27.10.93**

(21) Anmeldenummer: **88105067.8**

(22) Anmeldetag: **29.03.88**

(51) Int. Cl.⁵: **B08B 3/04**, C11D 7/26

(54) Verfahren zum Entfernen von Sägehilfsmittelresten von Scheiben.

(30) Priorität: **03.04.87 DE 3711262**

(43) Veröffentlichungstag der Anmeldung:
**05.10.88 Patentblatt 88/40**

(45) Bekanntmachung des Hinweises auf die
Patenterteilung:
**27.10.93 Patentblatt 93/43**

(84) Benannte Vertragsstaaten:
**DE FR GB IT**

(56) Entgegenhaltungen:
**EP-A- 0 130 786**
**DE-A- 1 617 075**
**DE-C- 745 281**
**US-A- 3 078 549**
**US-A- 3 589 468**

(73) Patentinhaber: **Wacker-Chemitronic Gesellschaft für Elektronik-Grundstoffe mbH
Johannes-Hess-Strasse 24
D-84489 Burghausen(DE)**

(72) Erfinder: **Brehm, Gerhard, Dr. Dipl.-Ing.
Forststrasse 27
D-8261 Emmerting(DE)**
Erfinder: **Knipf, Manuela
In den Grüben 128
D-8263 Burghausen(DE)**
Erfinder: **Mayrhuber, Rudolf Dipl.-Chem.
Hadermarkt 41
A-5121 Ostermiething(AT)**
Erfinder: **Schuhmacher, Jürgen
Weiherstrasse 7
D-8261 Haiming(DE)**
Erfinder: **Stadler, Max, Dr. Dipl.-Chem.
Pappelweg 2a
D-8261 Haiming(DE)**

## Beschreibung

Die Erfindung betrifft ein Verfahren zum Entfernen von Sägehilfsmittelresten von Scheiben, die durch Zersägen von stabförmigen Werkstücken, insbesondere Kristallstäben, erhalten werden.

Es ist bekannt, stabförmige Werkstücke, insbesondere Kristallstäbe, beispielsweise aus oxidischen Material wie z.B. Glas, Quarz, Gallium-Gadolinium-Granat, Saphir, Spinell oder aus Halbleitermaterial wie Silicium, Germanium, Galliumarsenid oder Indiumphosphid in dünne Scheiben zu zersägen. Die einwandfreie Abtrennung der Scheiben vom Werkstück wird dabei in vielen Fällen durch Sägehilfsmittel unterstützt, beispielsweise gemäß der DE-AS 10 66 28 bzw. der entsprechenden US-PS 30 78 549 durch Umhüllen des Werkstückes mit einem Kunstharzmantel aus Epoxidharz, gemäß der DE-OS 3010866 durch Zusammenkitten mehrerer Stäbe zu einem Stabbündel mittels Kunstharz oder z.B. gemäß der DE-OS 32 16 200 bzw. der entsprechenden US-PS 45 13 544 durch Aufkitten des Werkstückes mittels geeigneter Klebstoffe auf eine Schneidleiste z.B. aus Graphit oder keramischem Material, durch welche bei einem Mehrblattinnenlochsägeverfahren die abgetrennten Scheiben gehalten werden. Ähnliche Schneidleisten werden auch beim Innenlochsägen mit Einblattanordnungen angewendet, insbesondere wenn die Scheiben oder Scheibengruppen beim Sägevorgang vollständig abgetrennt und mit Hilfe von Abnehmervorrichtungen entnommen werden.

Vor der Weiterverarbeitung der erhaltenen Scheiben z.B. durch Läppen oder Polieren müssen die Reste solcher Sägenhilfsmittel entfernt werden. Aus der Patentschrift US-PS 35 89 468 ist ein Verfahren bekannt, bei dem während des Sägens eines Werkstückes ein Schaumkissen in den Schnittbereich gebracht wird, daß das Sägegeräusch senkt und den Schnittbereich reinigt. Der Schaum enthält beispielsweise organische Säuren wie Zitronen-, Wein- oder Oxal-Säure als Reinigungsmittel. In der eingangs genannten Druckschrift US-PS 30 78 549 werden zum Zweck der Entfernung von Sägehilfsmitteln die Scheiben in ein Bad aus Trichlorethylen oder Aceton eingelegt, wo der umgebende Kunstharzring zu quellen beginnt und sich ablöst. In ähnlicher Weise werden gewöhnlich auch die in der Regel mittels Epoxidharzkleber auf den Scheiben fixierten Reste der Schneidleisten durch Einbringen in ein Trichlorethylenbad entfernt.

Der Einsatz von organischen Lösungsmitteln wie Trichlorethylen oder Aceton bringt jedoch seit langem bekannte Probleme mit sich. Ein wichtiger Punkt sind dabei die gesundheitlichen Risiken, die von derartigen Lösungsmitteln für das Bedienungspersonal ausgehen können und die meist aufwendige Sicherheitsvorkehrungen und Abzugsanlagen notwendig machen, zumal die Bäder in der Regel bei erhöhten Temperaturen in der Nähe des Siedepunktes betrieben werden, um eine rasche Ablösung zu erzielen. Weiterhin ist die Entsorgung derartiger Lösungsmittel schwierig: verbrauchtes Trichlorethylen ist beispielsweise nicht biologisch abbaubar und muß daher z.B. durch Verbrennen beseitigt werden. In vielen Fällen sind auch die Feuergefährlichkeit und die niedrigen Flammpunkte mancher organischen Lösungsmittel zu beachten.

Aufgabe der Erfindung war es, ein Verfahren zum Entfernen von Sägehilfsmittelresten von Scheiben anzugeben, mir deren Hilfe eine vergleichbare oder bessere Wirksamkeit wie beim Einsatz der genannten Lösungsmittel, jedoch ohne deren Nachteile, erzielt werden kann.

Gelöst wird die Aufgabe durch ein Verfahren, welches dadurch gekennzeichnet ist, daß die Scheiben mit einer wäßrigen Lösung einer oder mehrerer, 1 bis 6 Kohlenstoffatome enthaltender Carbonsäuren in Kontakt gebracht und mit dieser bis zur Trennung der Verbindung zwischen Scheibe und Sägehilfsmittelrest in Kontakt gehalten werden.

Als Carbonsäuren kommen dabei sowohl Mono-, als auch Di- oder Tricarbonsäure in Frage. Beispiele für solche geeigneten Säuren sind Ameisensäure, Essigsäure, Propionsäure, Adipinsäure oder Citronensäure, wobei sich insbesondere die genannten Monocarbonsäuren mit 1 bis 3 C-Atomen bewährt haben. Bevorzugt wird Ameisensäure eingesetzt, die sich gegenüber den anderen Säuren als besonders wirksam erwiesen hat.

Die jeweils ausgewählten Säuren können innerhalb eines weiten Konzentrationsbereiches als wäßrige Lösungen vorgelegt werden, und zwar sowohl einzeln als auch im Gemisch. Grundsätzlich ist zwar bei den bei den gewählten Arbeitstemperaturen flüssigen Carbonsäuren wie z.B. Ameisen- oder Essigsäure selbst der Einsatz hochkonzentrierter Lösungen mit Säureanteilen von etwa 98 bis 99 Gew.-% nicht ausgeschlossen. Schon wegen der starken Geruchsbelästigung, des erhöhten Entzündungsrisikos und aus Kostengründen wird man jedoch auch in diesen Fällen den Säureanteil an der Lösung geringer halten. Vorteilhaft werden daher allgemein wäßrige Lösungen mit einem Säureanteil von 0,5 bis 70 Gew.-%, vorzugsweise 5 bis 50 Gew.-% verwendet. In der Regel wird man bei der letztendlich eingesetzten Konzentration die mit steigender Konzentration kürzere erforderliche Einwirkungszeit einerseits und den erhöhten Materialbedarf und den gestiegenen apparativen Aufwand andererseits berücksichtigen. In den meisten Fällen können diese Parameter anhand von Vorversuchen ermittelt und einander angepaßt werden.

Die bis zur Entfernung der Sägehilfsmittelreste von den Scheiben erforderliche Einwirkungszeit der jeweils ausgewählten wäßrigen Carbonsäurelösung läßt sich auch durch die Temperatur beeinflussen. Zweckmäßig werden die Lösungen mit 20 bis 100 °C, vorteilhaft 60 bis 95 °C eingesetzt, wobei steigende Temperaturen zu verkürzten Einwirkungszeiten führen. Oberhalb dieser Grenze sind in der Regel die Verluste durch abdampfende Lösung nicht mehr tolerierbar, während bei Temperaturen unterhalb 20 °C die Wirksamkeit deutlich nachläßt.

Gemäß einer besonderen Ausführungsform der Erfindung können der ausgewählten Lösung auch anorganische Säuren zugesetzt werden, die die zu behandelnden Scheiben nicht angreifen, und deren $pK_s$-Wert niedriger ist als der der anwesenden Carbonsäure oder Carbonsäuremischung. Im Falle der bevorzugten wäßrigen Ameisensäure ($pK_s$ ca. 3.7) und bei Silicium- oder Germaniumscheiben eignen sich dementsprechend beispielsweise die Salzsäure, Bromwasserstoffsäure, Jodwasserstoffsäure, Phosphorsäure oder Schwefelsäure, wobei natürlich auf die mögliche Kontamination der Scheiben mit Dotierstoffen zu achten ist. Zumeist ist es ausreichend, die jeweils ausgewählte anorganische Säure in einer Konzentration von bis zu 5 Gew.-%, bezogen auf die gesamte Lösung, zuzusetzen.

Eine andere Variante besteht darin, der wäßrigen Carbonsäurelösung zusätzlich oder alternativ zu den anorganischen Säuren bis zu ca. 10 Gew.-%, vorzugsweise bis ca. 5 Gew.-% von Substanzen zuzusetzen, die tensidische Eigenschaften aufweisen, beispielsweise Alkylsulfonate, Alkylarylsulfonate, Salze von langkettigen Carbonsäuren oder Ethylenoxidaddukte. Mit derartigen Lösungen läßt sich gleichzeitig mit der Entfernung der Sägehilfsmittel eine Reinigung der Scheibenoberfläche erzielen.

Zweckmäßig werden die ggf. mit den genannten Zusätzen versehenen wäßrigen Carbonsäure-, insbesondere Ameisensäurelösungen in Form eines oder mehrerer hintereinander geschalteter, vorteilhaft beheizbarer Bäder vorgelegt, in die die zu behandelnden Scheiben ggf. aufeinanderfolgend eingetaucht und bis zur Ablösung der Sägehilfsmittelreste belassen werden. Dabei kann auch eine Relativbewegung zwischen den Scheiben und dem im Bad befindlichen Mittel ausgeführt werden, beispielsweise durch Bewegen der Scheiben oder durch Umwälzen der Badflüssigkeit. Eine andere geeignete Möglichkeit, die Scheiben mit der wäßrigen Carbonsäurelösung in Kontakt zu bringen, besteht darin, diese zu besprühen oder einen Flüssigkeitsstrahl direkt im Bereich der vorgesehenen Trennstelle einwirken zu lassen.

Der Einsatz eines oder mehrerer Bäder hat den Vorteil, daß die Scheiben in den üblichen Prozeßhorden bereitgestellt werden können, wie sie beispielsweise für Oberflächenreinigungsprozesse gebräuchlich sind. Dabei ist allerdings zu beachten, daß diese Horden, die in der Regel Chargen von 25 Scheiben aufzunehmen vermögen, aus gegenüber dem im Bad vorgelegten Mittel resistentem Material gefertigt sind. Derartige geeignete Materialien sind beispielsweise Kunststoffe wie Polytetrafluorethylen oder Polypropylen; der nicht ausgeschlossene Einsatz von metallischen Werkstoffen wie z.B. Edelstahl birgt bei der Behandlung von Scheiben aus Halbleitermaterial die Gefahr einer unzulässigen Kontamination der Scheibenoberfläche. Zweckmäßig werden auch zumindest die Innenwände der die eingesetzten wäßrigen Lösungen aufnehmenden Behältnisse zur Vermeidung von Verunreinigungen aus derartigen resistenten Materialien gefertigt.

Durch die Einwirkung der ausgewählten wäßrigen Carbonsäurelösung wird die Bindung zwischen dem Scheibenrand und dem Sägehilfsmittelrest, welche in der Regel auf der Klebewirkung von Klebstoffen beruht, nach und nach immer mehr geschwächt, bis sie schließlich vollständig gelöst ist und der Sägehilfsmittelrest sich von der Scheibe abtrennt. Das erfindungsgemäße Verfahren eignet sich insbesondere zum Einsatz bei mittels Reaktionsklebstoffen auf der Basis von Epoxidharz-, Phenolharz-, Acrylatharz-, Cyanacrylat- oder Polyesterharzformulierungen hergestellten Bindungen zum Sägehilfsmittel, wobei ggf. auch der ausgehärtete Klebstoff selbst das Sägehilfsmittel darstellen kann. Typische Beispiele sind etwa das Zertrennen von Kristallstäben aus Halbleiter- oder oxidischem Material in dünne Scheiben mittels Innenlochsäge, bei dem die Stäbe vor dem Sägen meist mittels Epoxidharzklebstoff auf eine Schneidleiste aus beispielsweise keramischem Material, Glas oder Kohlenstoff aufgeklebt und in der Halterung befestigt werden. Beim Sägen wird mit jeder Scheibe auch ein Teil der Schneidleiste abgetrennt und bleibt zunächst an dieser fixiert. Auch beim Gattersägen von beispielsweise Blöcken aus grobkristallinem Silicium für Solarzellen werden häufig Sägehilfsmittel wie beispielsweise Glaskeile auf die Blöcke aufgeklebt, deren Reste dann zunächst an den erhaltenen Scheiben fixiert verbleiben. Weiterhin ist als Beispiel das Zertrennen von optischem Material, beispielsweise Glas, in Scheiben zu nennen, bei dem häufig der Sägevorgang durch das Anbringen von Schneidleisten an den Werkstücken unterstützt wird. Selbstverständlich sind die hier genannten Beispiele nicht im Sinne einer Beschränkung des Erfindungsgedankens zu verstehen.

Die zum Entfernen der Sägehilfsmittelreste von den erhaltenen Scheiben eingesetzten wäßrigen Carbonsäurelösungen, insbesondere auf Basis von Ameisensäure, zeigen eine im Vergleich zu dem bisher üblichen organischen Lösungsmitteln wie Trichlorethylen oder Aceton annähernd gleiche oder höhere Wirksamkeit. Daneben besitzen diese Lösungen den Vorteil eines erheblich reduzierten oder vernachläßigbaren Entzündungsrisikos, und deutlich geringerer gesundheitlicher Gefahren für das Bedienungspersonal. Des weiteren ist die Entsorgung wenig problematisch, da die genannten Lösungen in der Regel biologisch abbaubar sind.

Das erfindungsgemäße Verfahren wird anhand der nachstehenden Ausführungsbeispiele näher erläutert:

Beispiel 1:

Ein durch Tiegelziehen nach Czochralski erhaltener Siliciumstab (Durchmesser ca. 10 cm, Länge ca. 100 cm) wurde mit Hilfe einer handelsüblichen Innenlochsäge in dünne Scheiben von ca. 400 $\mu$m Dicke zersägt. Zur Unterstützung des Sägevorganges war der Stab mittels eines unter dem Handelsnamen "Araldit" vertriebenen Klebers auf Epoxidharzbasis auf eine Schneidleiste aus Graphit (Querschnitt ca. 12 x 25 mm$^2$) aufgeklebt, die gleichzeitig als Hilfsmittel zur Halterung des Stabes und zur Verhinderung von Ausbrüchen in der Endphase jedes Schnittes diente. Am Außenumfang jeder abgetrennten Scheibe verblieb dabei ein Restabschnitt der Schneidleiste. Insgesamt wurden 120 Scheiben gesägt.

Zur Entfernung des anhaftenden Restabschnittes wurden nun jeweils 10 dieser Scheiben in ein mit einem dafür geeigneten Mittel gefülltes Bad eingetaucht und in diesem belassen, bis sich alle Restabschnitte von den Scheiben gelöst hatten. Für jede einzelne Scheibe wurde dabei die erforderliche Einwirkungsdauer zwischen dem Eintauchen und der Ablösung des Schneidleistenrestes gemessen und schließlich aus diesen Werten für alle 10 Scheiben der Mittelwert gebildet. Als Badflüssigkeit wurden dabei wäßrige Lösungen der Ameisensäure, Essigsäure, Propionsäure, Adipinsäure und Citronensäure in verschiedenen Konzentrationen bei einer Temperatur von jeweils ca. 90°C vorgelegt. Zum Vergleich wurden 10 Scheiben auch in einem auf Siedetemperatur (ca. 87°C) gehaltenen, mit Trichlorethylen gefüllten Bad behandelt. Die dabei gefundenen Ergebnisse sind in der Tabelle gegenübergestellt.

Tabelle: Erforderliche Einwirkungsdauer bis zur Ablösung des Restes der Schneidleiste bei Siliciumscheiben mit 400 $\mu$m Dicke in verschiedenen Badflüssigkeiten

| Badflüssigkeit | Säureanteil (Gew.-%) | Badtempera- tur (°C) | Einwirkungs- dauer (min) |
|---|---|---|---|
| Ameisensäure/ Wasser | 30 | 90 | 0.25 |
| | 15 | 90 | 0.38 |
| | 5 | 90 | 0.75 |
| Essigsäure/ Wasser | 50 | 90 | 0.33 |
| | 30 | 90 | 0.75 |
| | 15 | 90 | 1.25 |
| Propionsäure/ Wasser | 5 | 90 | 3.0 |
| Citronensäure/ Wasser | 50 | 90 | 6.5 |
| Adipinsäure/ Wasser | 50 | 90 | 4 |
| Trichlorethylen 100 % | - | 87 | 3.2 |

Beispiel 2:

Jeweils 10 der gemäß Beispiel 1 gesägten Scheiben wurden in auf Raumtemperatur (ca. 25 °C) gehaltene Bäder eingebracht, wobei als Badflüssigkeit im ersten Fall 50 gewichtsprozentige Ameisensäure, im zweiten 50 gewichtsprozentige Essigsäure und im dritten Trichlorethylen eingesetzt wurde. Im Ameisensäurebad waren bereits nach ca. 1 Stunde, im Essigsäurebad nach ca. 3 Stunden und im Trichlorethylenbad erst nach ca. 10 Stunden alle Restabschnitte von den Scheiben abgetrennt.

Beispiel 3:

Es wurden zwei Bäder mit 15 gewichtsprozentiger Ameisensäure (Badtemperatur jeweils 65°C) vorgelegt. In einem der Bäder wurden der Badflüssigkeit zusätzlich ca. 2 Gew.-% eines kommerziell erhältlichen Tensids auf Alkylsulfonat-Basis zugesetzt.

In beiden Bädern wurden nun für ca. 1 Minute synchron jeweils 10 oberflächlich mit starken Schlieren von Sägeabrieb verunreinigte Siliciumscheiben bewegt.

Nach dieser Behandlung hatten sich bei beiden Scheibengruppen die Restabschnitte der Schneidleiste abgelöst. Auf der Oberfläche der in dem tensidhaltigen Bad behandelten Scheiben ließen sich visuell keine Schlieren mehr nachweisen, während die in dem tensidfreien Bad behandelten Scheiben noch Schlieren auf der Scheibenoberfläche zeigten.

## Patentansprüche

1. Verfahren zum Entfernen von Sägehilfsmittelresten von Scheiben, die durch Zersägen von stabförmigen Werkstücken, insbesondere Kristallstäben, erhalten werden, dadurch gekennzeichnet, daß die Scheiben mit einer wäßrigen Lösung einer oder mehrerer, 1 bis 6 Kohlenstoffatome enthaltender Carbonsäuren in Kontakt gebracht und mit dieser bis zur Trennung der Verbindung zwischen Scheibe und Sägehilfsmittelrest in Kontakt gehalten werden.

2. Verfahren nach Anspruch 1, dadurch gekennzeichnet, daß als Carbonsäuren Monocarbonsäuren mit 1 bis 3 C-Atomen eingesetzt werden.

3. Verfahren nach Anspruch 1 oder 2, dadurch gekennzeichnet, daß als Carbonsäure Ameisensäure eingesetzt wird.

4. Verfahren nach einem oder mehreren der Ansprüche 1 bis 3, dadurch gekennzeichnet, daß der Anteil der Carbonsäuren an der wäßrigen Lösung auf 0.5 bis 70 Gew.-% eingestellt wird.

5. Verfahren nach einem oder mehreren der Ansprüche 1 bis 4, dadurch gekennzeichnet, daß die wäßrige Lösung als Bad vorgelegt wird.

6. Verfahren nach Anspruch 5, dadurch gekennzeichnet, daß das Bad auf einer Temperatur von 20 bis 100°C, vorzugsweise 60 bis 95°C gehalten wird.

7. Verfahren nach einem oder mehreren der Ansprüche 1 bis 6, dadurch gekennzeichnet, daß der wäßrigen Lösung bis zu 10 Gew.-% Tenside und/oder bis zu 5 Gew.-% einer anorganischen, die Scheiben nicht angreifenden Säure zugesetzt werden, deren $pK_s$-Wert niedriger ist als der der vorgelegten Carbonsäure.

## Claims

1. Method for removing residues of auxiliary sawing materials from slices which are obtained by sawing up rod-shaped workpieces, in particular crystalline rods, characterised in that the slices are brought into contact with an aqueous solution of one or more carboxylic acids containing 1 to 6 carbon atoms and are kept in contact with the latter until the bond between slice and residue of auxiliary sawing material is separated.

2. Method according to Claim 1, characterised in that monocarboxylic acids containing 1 to 3 carbon atoms are used as carboxylic acids.

3. Method according to Claim 1 or 2, characterised in that formic acid is used as carboxylic acid.

4. Method according to one or more of the Claims 1 to 3, characterised in that the proportion of carboxylic acids in the aqueous solution is adjusted to 0.5 to 70% by weight.

5. Method according to one or more of Claims 1 to 4, characterised in that the aqueous solution is provided as a bath.

6. Method according to Claim 5, characterised in that the bath is kept at a temperature of 20 to 100°C, preferably 60 to 95°C.

7. Method according to one or more of Claims 1 to 6, characterised in that up to 10% by weight of surfactants and/or up to 5% by weight of an inorganic acid whose $pK_a$ value is lower than that of the carboxylic acid provided and which does not attack the slices, are added to the aqueous solution.

**Revendications**

1. Procédé pour éliminer les résidus d'auxiliaire de sciage se trouvant sur des tranches, obtenues en particulier par sciage de pièces en oeuvre en forme de barre, notamment des barres cristallines, caractérisé en ce que les tranches sont mises en contact avec une solution aqueuse d'un ou plusieurs acides carboxyliques contenant 1 à 6 atomes de carbone et sont maintenues en contact avec cette dernière jusqu'à séparation de la liaison entre la tranche et le résidu d'auxiliaire de sciage.

2. Procédé selon la revendication 1, caractérisé en ce qu'on utilise comme acides carboxyliques des acides monocarboxyliques ayant de 1 à 3 atomes de carbone.

3. Procédé selon les revendications 1 ou 2, caractérisé en ce qu'on utilise comme acide carboxylique de l'acide formique.

4. Procédé selon l'une ou plusieurs des revendications 1 à 3, caractérisé en ce que la quantité des acides carboxyliques dans la solution aqueuse est ajustée à 0,5-70 % en poids.

5. Procédé selon l'une ou plusieurs des revendications 1 à 4, caractérisé en ce que la solution aqueuse se présente sous forme d'un bain.

6. Procédé selon la revendication 5, caractérisé en ce que le bain est maintenu a une température de 20 à 100°C et de préférence de 60 à 95°C.

7. Procédé selon l'une ou plusieurs des revendications 1 à 6, caractérisé en ce qu'on ajoute à la solution aqueuse jusqu'à 10 % en poids de tensioactifs et/ou jusqu'à 5 % en poids d'un acide minéral qui n'attaque pas les tranches, dont le pKa est inférieur à celui de l'acide carboxylique / déjà en place.